# EUROPÄISCHE PATENTANMELDUNG

(11) **EP 1 296 369 A1**
(43) Veröffentlichungstag der Anmeldung: **26.03.2003**
(21) Anmeldenummer: 01122468.0
(22) Anmeldetag: 20.09.2001
(51) Int. Cl.: H01L 21/8242

(54) **Verfahren zur Herstellung von Gateoxyd für Trench Gate DRAM Zellen**

(71) Anmelder: Infineon Technologies AG, 81669 München (DE)
(72) Erfinder: Seidl, Harald, 01099 Dresden (DE); Goebel, Bernd, 01099 Dresden (DE); Moll, Peter, 01099 Dresden (DE)
(74) Vertreter: Müller - Hoffmann & Partner

(57) **Zusammenfassung**

Die Erfindung betrifft einen Vertikal-Transistor für eine DRAM-Speicherzelle, bei dem als Gateisolator eine abgeschiedene Schicht (18) verwendet wird, die gleichzeitig zur elektrischen Isolation zwischen dem Transistor und einem Speicherkondensator dient.

## Beschreibung

Die vorliegende Erfindung betrifft einen Vertikal-Transistor nach dem Oberbegriff des Patentanspruches 1 sowie ein Verfahren zu dessen Herstellung.

In dynamischen Schreib-Lese-Speichern (DRAMs) werden derzeit bevorzugt sogenannte 1-Transistor-Zellen eingesetzt. Eine 1-Transistor-Zelle besteht bekanntlich aus einem Speicherkondensator und einem Auswahltransistor. Eine Elektrode des Kondensators liegt auf festem Potential, während dessen die andere Elektrode, die sogenannte Speicherelektrode, über die Source-Drain-Strecke des Auswahltransistors mit einer Bitleitung verbunden ist und die Gateelektrode des Auswahltransistors über eine Wortleitung angesteuert wird. Aus Platzgründen wird der Speicherkondensator häufig als sogenannter Trench-Kondensator ausgebildet. Bei einem solchen Trench-Kondensator wird in ein Substrat, insbesondere ein Halbleiter- bzw. Siliziumsubstrat ein Loch geätzt, in das ein Dielektrikum sowie eine Speicherelektrode eingebracht werden, wobei die auf festem Potential liegende Elektrode des Speicherkondensators durch einen hochdotierten Bereich im Siliziumsubstrat gebildet wird.

Üblicherweise wird derzeit der Auswahltransistor auf der planaren Oberfläche des Substrates neben dem Speicherkondensator vorgesehen. Eine derart aufgebaute Speicherzelle benötigt mindestens eine Fläche von 8 F², wobei F die minimale Strukturgröße bei der Lithographie bedeutet.

Bislang wird bei DRAMs ausschließlich die sogenannte gefaltete bzw. "Folded-Bitline-Verschaltung" eingesetzt. Diese Folded-Bitline-Verschaltung ist notwendig, um durch den dadurch bedingten Kapazitätsausgleich kleine Signalpegel auswerten zu können. Die Folded-Bitline-Verschaltung erfordert aber, dass auf der gleichen Zellfläche des Substrates die doppelte Anzahl von Wortleitungen wie ohne Folded-Struktur untergebracht werden muss.

Um bei Anwendung einer Folded-Bitline-Verschaltung eine Zellfläche von 8 F² zu gewährleisten, darf eine Wortleitung nur eine Breite von 1 F haben. Dies hat aber zur Folge, dass ein in der planaren Oberfläche des Substrates neben dem Speicherkondensator vorgesehener Auswahltransistor maximal eine Kanallänge von 1 F aufweisen kann.

Für zukünftige Technologie-Generationen, die eine minimale Strukturgröße F vorsehen, welche kleiner als 100 nm ist, kann nicht erwartet werden, dass entsprechende Auswahltransistoren die an sie zu stellenden Anforderungen hinsichtlich geringer Leckströme und Performance (entspricht maximalem Zellstrom) erfüllen können. Vielmehr sind bei minimalen Strukturgrößen deutlich unterhalb 100 nm hohe Leckströme und ein deutliches Absinken der Performance zu befürchten.

Um dieses Problem zu umgehen, wurden bereits Konzepte vorgeschlagen, bei denen die Kanallänge des Auswahltransistors konstant gehalten wird, wobei hier der Auswahltransistor vertikal, also senkrecht zur planaren Richtung ausgeführt und über dem Speicherkondensator angeordnet ist. Das Beibehalten einer minimalen Transistor-Kanallänge führt jedoch zwangsläufig zu einem immer größer werdenden Widerstandswert des Kanals, da das Verhältnis Kanallänge/Kanalweite mit abnehmender minimaler Strukturgröße immer größer wird.

Es gibt jedoch bereits Konzepte, die dieses Problem eines immer höher werdenden Widerstandes des Kanales des Auswahltransistors durch ein das aktive Gebiet des Auswahltransistors umschließendes Gate lösen. Bei allen diesen Konzepten mit vertikalen Auswahltransistoren ist es von entscheidender Bedeutung, dass die Gateisolierschicht, im Folgenden auch Gateoxid genannt, mit sehr guter Gleichförmigkeit auf dem aktiven Gebiet des Auswahltransistors aufgebracht werden kann.

Bisher werden als Gateoxide für DRAMs ausschließlich thermisch erzeugte Oxide, also insbesondere thermisch erzeugtes Siliziumdioxid verwendet. Die Aufwachsrate von thermisch erzeugtem Siliziumdioxid hat jedoch die Eigenschaft, dass sie von der Kristallorientierung abhängig ist. Außerdem zeigen thermisch erzeugte Oxide speziell bei Prozesstemperaturen unterhalb 1000 °C in Bereichen mit einem hohen Krümmungsradius eine deutlich verringerte Aufwachsrate.

Beide Phänomene, nämlich die Abhängigkeit der Aufwachsrate von der Kristallorientierung einerseits und von dem Krümmungsradius des jeweiligen Bereiches andererseits, bedingen zwangsläufig eine unerwünschte Verschlechterung der Gleichförmigkeit von thermisch erzeugten Gateoxiden und damit auch eine Beeinträchtigung von Performance und Zuverlässigkeit des jeweiligen Auswahltransistors.

Um bei den bisher verwendeten thermischen Oxiden eine ausreichende elektrische Isolation zwischen dem Auswahltransistor und dem Speicherkondensator zu gewährleisten, muss bei dem oben erwähnten Konzept eines vertikalen Auswahltransistors über einem Kondensator eine ausreichende elektrische Isolation zwischen dem Auswahltransistor und dem Speicherkondensator gewährleistet werden. Dies geschieht derzeit durch Abscheidung eines sogenannten Trench-Top-Oxides (TTO), das zwischen Speicherkondensator und Auswahltransistor im Trench vorgesehen ist und einen gesonderten Herstellungsschritt erfordert.

Es ist Aufgabe der vorliegenden Erfindung, für eine DRAM-Speicherzelle einen Vertikal-Transistor anzugeben, der sich durch gute Performance bei hoher Zuverlässigkeit auszeichnet; außerdem soll ein Verfahren zum Herstellen eines solchen Vertikal-Transistors geschaffen werden.

Diese Aufgabe wird bei einem Vertikal-Transistor der eingangs genannten Art erfindungsgemäß durch die im kennzeichnenden Teil des Patentanspruches 1 angegebenen Merkmale gelöst. Ein vorteilhaftes Verfahren zum Herstellen eines solchen Vertikal-Transistors ist im Patentanspruch 4 angegeben.

Vorteilhafte Weiterbildungen der Erfindung ergeben sich aus den Unteransprüchen.

Bei dem erfindungsgemäßen Vertikal-Transistor wird eine abgeschiedene Dielektrikum-Schicht als Gateoxid verwendet. Diese Dielektrikum-Schicht kann durch ALD (Atomic Layer Deposition = Atom-Schicht-Abscheidung) bzw. atomare Schichtablagerung, auch ALCVD, CVD (Chemical Vapour Deposition = chemische Dampfabscheidung) oder ähnliche Verfahren hergestellt sein. Durch diese Verfahren wird jedenfalls eine hervorragende Konformalität des Gateoxids erreicht werden, wobei die Aufwachsrate jeweils von der Kristallorientierung und Krümmung der Oberfläche des Substrates unabhängig sind.

Außerdem ist es möglich, für die Dielektrikum-Schicht außer Siliziumdioxid auch andere Dielektrika mit höheren Dielektrizitätskonstanten, wie beispielsweise Si₃N₄, Al₂O₃ und ähnliche Materialien einzusetzen. Durch eine abgeschiedene Dielektrikum-Schicht für das Gateoxid ergibt sich jedenfalls die Möglichkeit, die Performance des Auswahltransistors bei unveränderter Geometrie erheblich zu verbessern. Insbesondere ist es auch möglich Gateoxide aus Kombinationen bzw. Stapel von verschiedenen Materialien, wie beispielsweise SiO₂/SiN, SiO₂/Al₂O₃/SiO₂, usw. zu erzeugen.

Bevorzugte Schichtdicken der Dielektrikum-Schicht liegen zwischen 2 und 20 nm. Es sind aber auch kleinere oder größere Dicken möglich.

Schließlich kann durch den Einsatz einer abgeschiedenen Dielektrikum-Schicht auf den Schritt der Abscheidung eines TTO verzichtet werden.

Wesentlich an der vorliegenden Erfindung ist also die Abscheidung des Gate-Dielektrikums für den Vertikal-Transistor mittels ALD, CVD oder ähnlichen Verfahren. Weiterhin können bei dem erfindungsgemäßen Vertikal-Transistor Materialien mit höherer Dielektrizitätskonstanten als Siliziumdioxid, nämlich Siliziumnitrid (Si₃N₄), Aluminiumoxid (Al₂O₃) oder ähnliche Materialien eingesetzt werden, um so die Performance des Auswahltransistors zu steigern, ohne den Leckstrom durch das Gate-Dielektrikum zu erhöhen. Schließlich wird durch die Verwendung einer abgeschiedenen Dielektrikum-Schicht als Gateoxid die elektrische Isolation zwischen dem Auswahltransistor und dem Speicherkondensator verbessert, so dass diese elektrische Isolation von der Dielektrikum-Schicht übernommen wird und auf TTOs verzichtet werden kann.

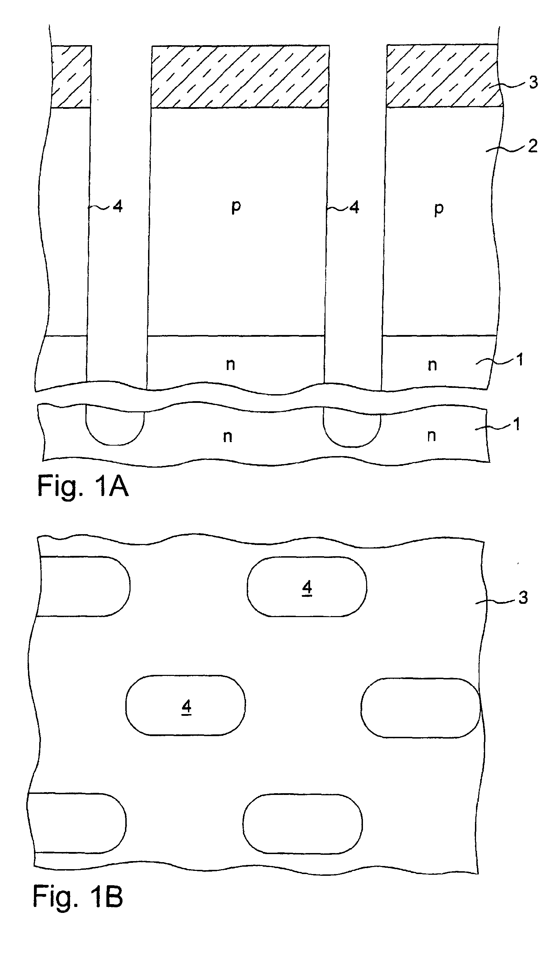

Nachfolgend wird die Erfindung anhand der Zeichnungen näher erläutert, in deren Fig. 1 bis 8 Schnitte (A) bzw. Draufsichten (B) auf den Vertikal-Transistor in jeweils unterschiedlichen Verfahrensschritten gezeigt sind. Die Figuren B sind dabei um 90° gegenüber den Figuren A gedreht.

Die Figuren 1A und 1B zeigen eine beispielsweise aus Arsenglas in einem p-leitenden Siliziumsubstrat ausdiffundierte n-dotierte Buried Plate 1 (vergrabene Platte), eine beispielsweise durch Epitaxie auf dem Siliziumsubstrat hergestellte p-dotierte Siliziumschicht 2, die mit beispielsweise 1 x 10¹⁵ Fremdatomen/cm³ dotiert ist. Als Dotierstoff kann beispielsweise Bor verwendet werden. Auf dieser Siliziumschicht 2 ist noch eine Siliziumnitridschicht 3 vorgesehen, in die Trenches 4 eingebracht sind.

Die Herstellung der in den Figuren 1A und 1B gezeigten Anordnung erfolgt in üblicher Weise durch einzelne Maskier- und Ätzschritte.

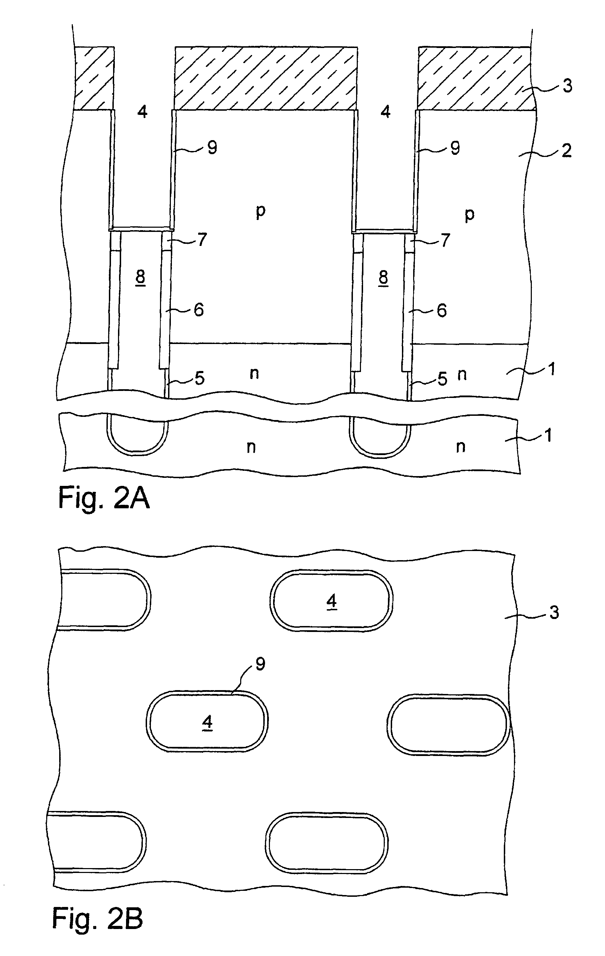

Die Trenches 4 werden sodann, wie in den Fig. 2A und 2B gezeigt ist, mit einer Isolierschicht 5 aus beispielsweise Siliziumnitrid, einer Siliziumdioxidschicht (beispielsweise TEOS = Tetraethylenorthosilikat) 6 und einer Schicht 7 aus undotiertem amorphem Silizium im unteren Randbereich und im Innenraum dieses unteren Randbereiches mit beispielsweise n-dotiertem polykristallinem Silizium 8 gefüllt.

Hierzu wird zunächst die Isolierschicht 5 erzeugt. Sodann wird polykristallines Silizium abgeschieden, das beispielsweise n-dotiert ist und eine Schichtdicke von 200 nm haben kann. Dieses polykristalline Silizium, das später die Schicht 8 bildet, wird sodann rückgeätzt. Die dadurch freiliegenden Teile der Isolierschicht 5 werden anschließend mit beispielsweise HF zurückgeätzt. Dann wird Siliziumdioxid (beispielsweise TEOS = Tetraethylenorthosilikat), das später die Schicht 6 bildet, mit einer Schichtdicke von beispielsweise 20 nm abgeschieden und mit beispielsweise CHF₃+O₂ anisotrop geätzt, um so Spacer zu bilden. Es wird erneut polykristallines Silizium abgeschieden, das n-dotiert sein kann und beispielsweise 200 nm dick ist. Das polykristalline Silizium wird anschließend rückgeätzt, sodann wird die Schicht 6 beispielsweise mit HF isotrop rückgeätzt. Es schließt sich die Abscheidung von undotiertem amorphem Silizium an, das nach einem Rückätzen die Schicht 7 bildet. Schließlich folgt eine thermische Oxidation der Trench-Seitenwände, um eine beispielsweise 5 nm dicke Siliziumdioxidschicht 9 zu bilden.

Durch diesen Schritt kann der sonst erforderliche TTO-Prozess ersetzt werden. Es liegt damit die in Fig. 2A bzw. 2B gezeigte Struktur vor.

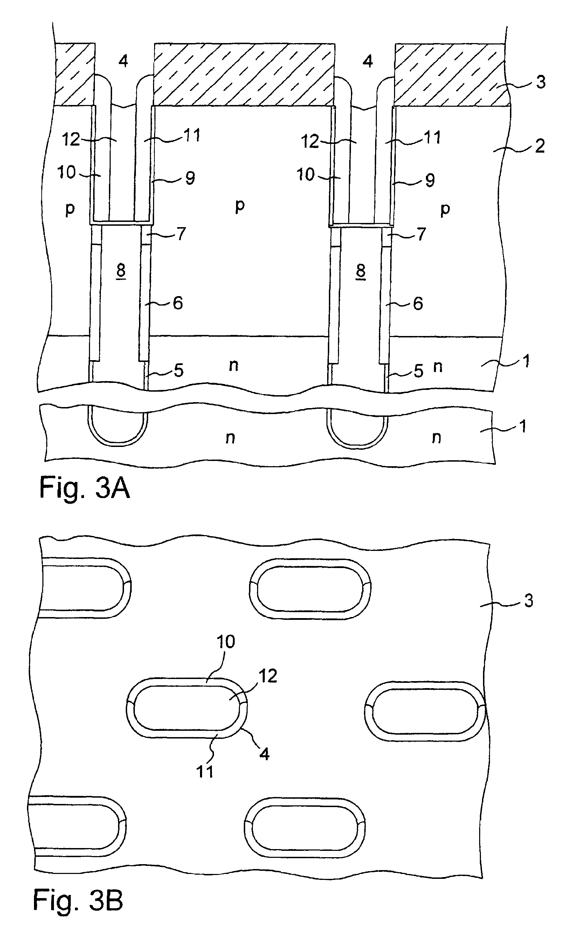

In den verbleibenden Trench 4 (vergleiche Fig. 2A) werden sodann durch Abscheidung und einseitige Implantation sowie Rückätzung p⁺-dotiertes polykristallines Silizium 10 (anstelle einer p⁺-Dotierung kann gegebenenfalls auch eine n⁺-Dotierung gewählt werden) und undotiertes polykristallines Silizium 11 eingebracht. Nach Rückätzung dieses polkristallinen Siliziums wird der Trench 4 in seinem oberen Bereich zwischen dem dotierten polykristallinem Silizum 10 und dem undotierten Silizium 11 mit Siliziumdioxid 12 gefüllt, welches anschließend rückgeätzt wird. Damit liegt die in Fig. 3A bzw. 3B gezeigte Struktur vor.

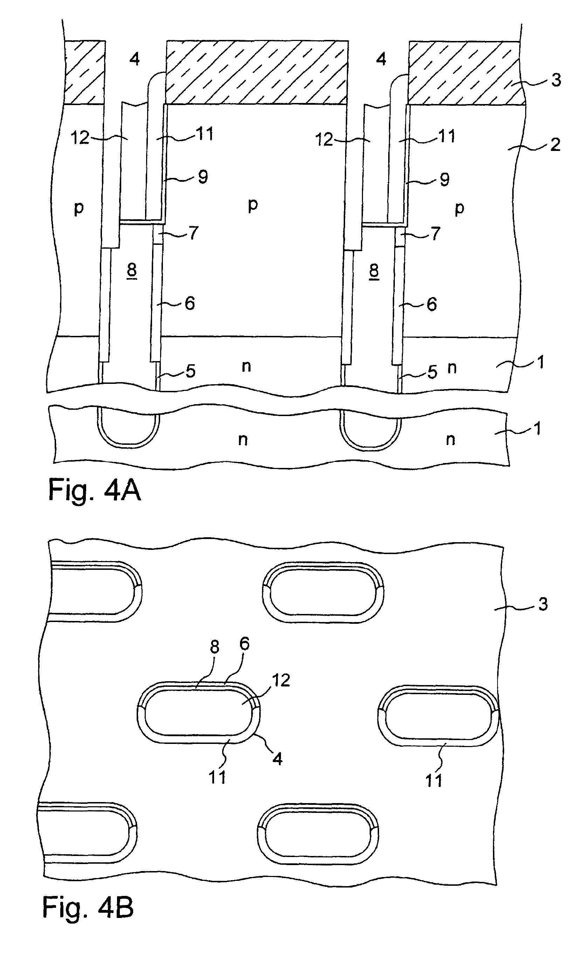

Das p⁺-dotierte polykristalline Silizium 10 (oder alternativ das undotierte polkristalline Silizium 11) wird sodann selektiv geätzt. Die durch diese Ätzung freigelegte thermische Siliziumdioxidschicht 9 wird rückgeätzt, und der dadurch freigelegte Bereich der Schicht 7 aus amorphem Silizium wird ebenfalls durch Ätzen abgetragen. Es wird damit die in Fig. 4A bzw. 4B gezeigte Struktur erhalten.

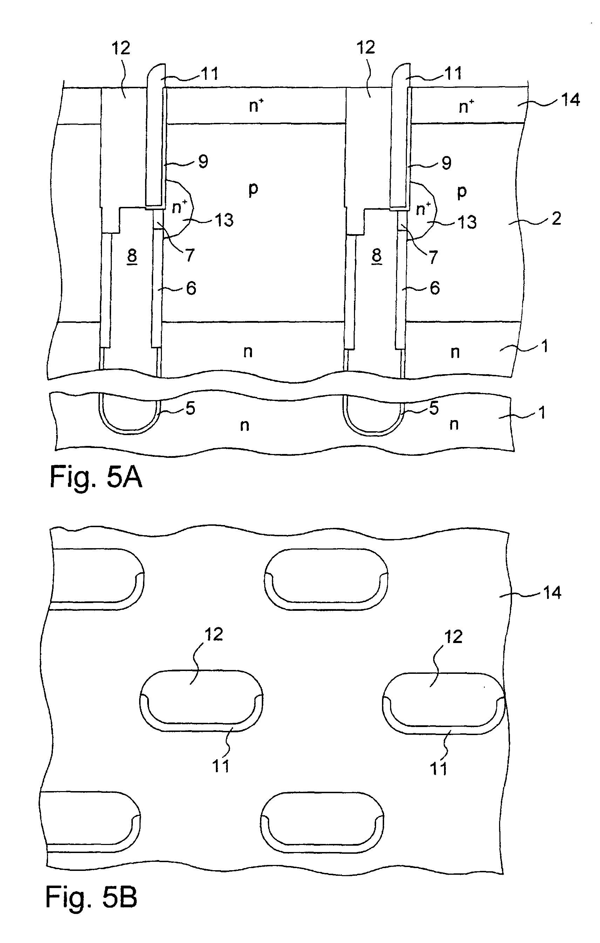

Nach Abscheiden von Siliziumdioxid (beispielsweise TEOS), chemisch-mechanischem Polieren (CMP), Rückätzen des Siliziumdioxids und Entfernen der Siliziumnitridschicht 3 durch Ätzen werden eine p-dotierte Wanne sowie eine n⁺-dotierte Oberflächenschicht 14 jeweils durch Implantation von beispielsweise Bor für die p-dotierte Wanne und Arsen für die n⁺-dotierte Schicht 14 und anschließendes Ausheilen erzeugt. Damit liegt die in Fig. 5A bzw. 5B gezeigte Struktur vor.

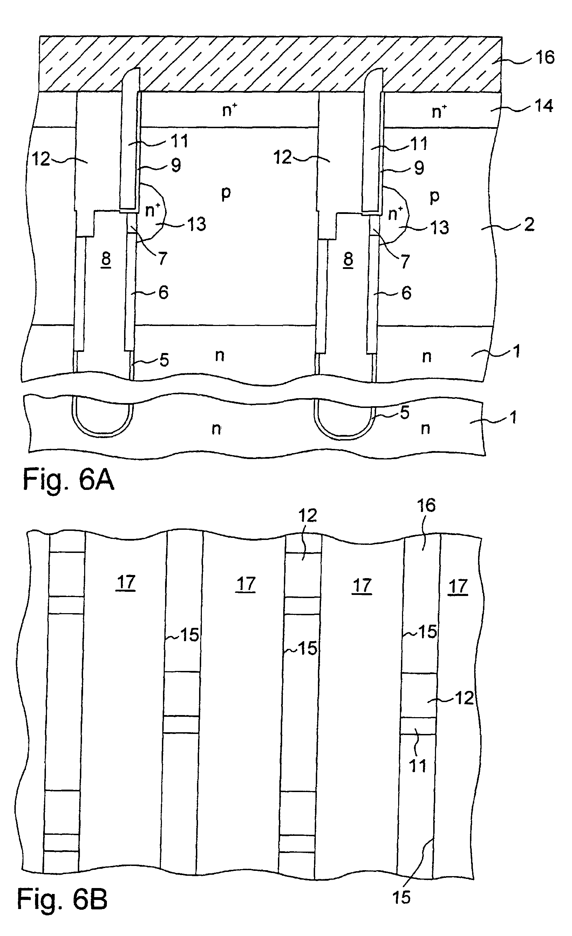

Auf die Oberfläche der in den Fig. 6A und 6B gezeigten Anordnung wird sodann eine Siliziumnitridschicht 16 aufgetragen, und mit Hilfe einer Fotolack- und Ätztechnik werden sodann Trenches 15 eingebracht. Diese Trenches 15 verlaufen jeweils im Randbereich der Trenches 4, wie dies in Fig. 6B gezeigt ist. In der Fig. 6A sind diese Trenches 15 nicht zu sehen, da sie vor oder hinter der Zeichenebene die Trenches 4 "schneiden".

Die Trenches 15 werden mit Siliziumdioxid (beispielsweise TEOS) 17 gefüllt und mittels CMP und Rückätzung planarisiert. Damit liegt die in Fig. 6A bzw. 6B gezeigte Struktur vor.

Nach Entfernen der Siliziumnitridschicht 16 wird das undotierte polykristalline Silizium 11 selektiv geätzt, und das Siliziumdioxid 17 wird isotrop geätzt.

Anschließend wird erfindungsgemäß durch ALD, CVD oder ein ähnliches Verfahren als Gate-Dielektrikum eine Schicht 18 durch Abscheidung und keinesfalls thermische Oxidation aufgetragen. Für diese Schicht 18 kann Siliziumdioxid, Siliziumnitrid, Aluminiumoxid oder ein ähnliches Material verwendet werden. Die Schicht 18 wird als Gateoxid genutzt und isoliert später den Auswahltransistor (im oberen Bereich des Trenches 4) vom Speicherkondensator (im unteren Bereich des Trenches 4).

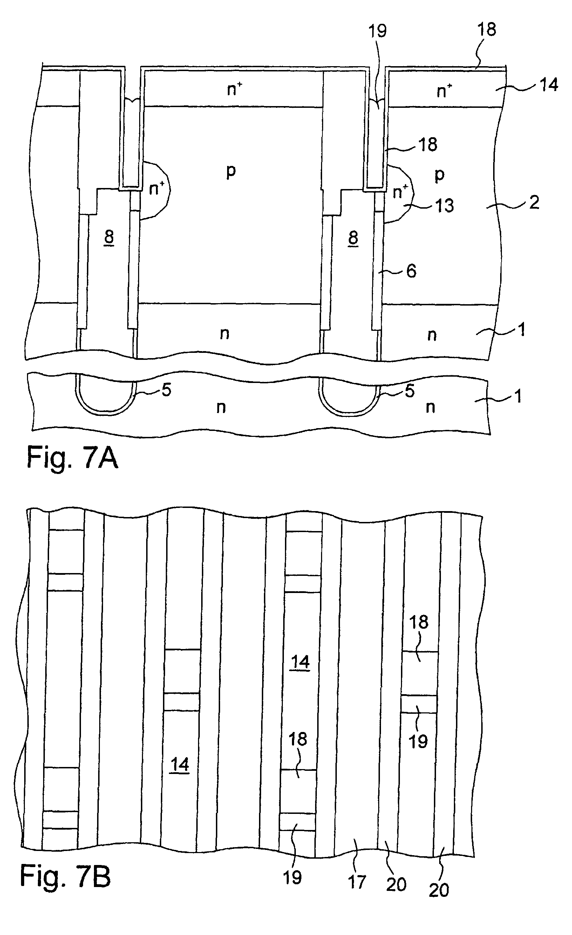

Nach Abscheidung von beispielsweise n-dotiertem polykristallinem Silizium 19 und Wolframschichten 20 und anisotroper Ätzung dieser Schichten liegt die in Fig. 7A bzw. 7B dargestellte Struktur vor (in Fig. 7B ist die auf der Siliziumdioxidschicht 17 und der n⁺-dotierten Schicht 14 vorgesehene Schicht 18 der besseren Übersichtlichkeit wegen weggelassen).

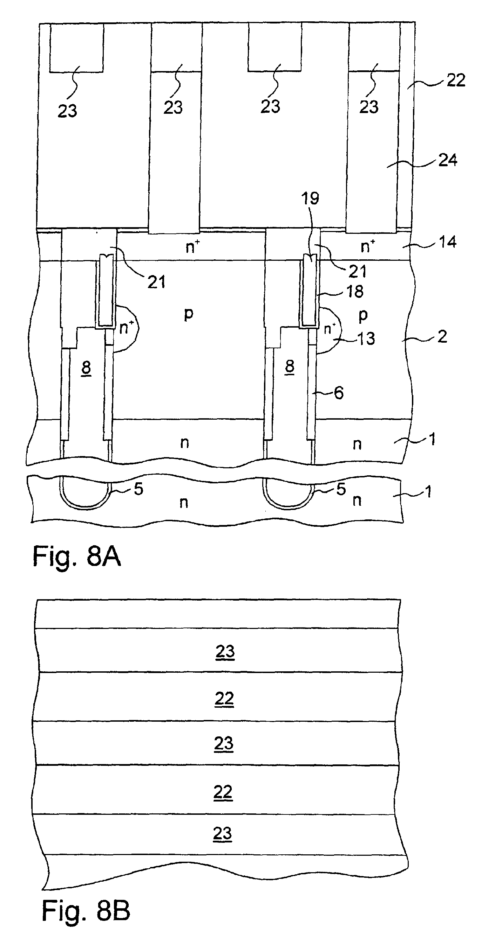

Nach Abscheidung von Siliziumnitrid 21 im Bereich oberhalb der Trenches 4 und Rückätzen dieses Siliziumnitrids 21 wird eine Siliziumdioxidschicht 22 aufgetragen, in die in üblicher Weise eine Metallisierung aus Wolframsilizid 23 und dotiertem polkristallinem Silizium 24 eingebracht wird. Damit liegt schließlich die in den Fig. 8A bzw. 8B gezeigte Struktur vor.

Wie aus der Fig. 8A zu ersehen ist, besteht ein Vertikal-Transistor aus der Schicht 14 als beispielsweise Source oder Drain, der Siliziumschicht 2 als Bodykörper, der Schicht 13 als Drain bzw. Source und dem Polysilizium 19 als Gateelektrode. Diese ist hinter oder vor der Zeichenebene von Fig. 8A mit einer Wortleitung verbunden.

Der Speicherkondensator weist das polykristalline Silizium 8 als mit Source bzw. Drain des Auswahltransistors verbundene eine Elektrode und Buried Plate 1 als auf festem Potential liegende andere Elektrode auf.

### Bezugszeichenliste

- 1: Siliziumkörper
- 2: Siliziumschicht
- 3: Siliziumnitridschicht
- 4: Trench
- 5: Isolierschicht
- 6: Siliziumdioxidschicht
- 7: Schicht aus amorphem Silizium
- 8: Polykristallines Silizium
- 9: Thermische Siliziumdioxidschicht
- 10: P⁺-dotiertes polykristallines Silizium
- 11: Undotiertes polykristallines Silizium
- 12: Siliziumdioxid
- 13: n⁺-dotierte Wanne
- 14: n⁺-dotierte Schicht
- 15: Trench
- 16: Siliziumnitridschicht
- 17: Siliziumdioxid
- 18: Schicht, hergestellt durch CVD, ALD und dergleichen
- 19: Polykristallines Silizium
- 20: Wolframschicht 21
- 21: Siliziumnitrid
- 22: Siliziumdioxidschicht
- 23: Wolframsilizit
- 24: Polykristallines Silizium

## Patentansprüche

1. Vertikal-Transistor für DRAM-Speicherzelle, bei der der Vertikal-Transistor in der Seitenwand eines Trenches (4) über einem im Bodenbereich von diesem vorgesehenen Speicherkondensator angeordnet ist, wobei der Transistor vom Speicherkondensator durch eine erste Isolierschicht getrennt ist und der Transistor als Gateisolator eine zweite Isolierschicht hat,
**dadurch gekennzeichnet,**
**dass** die erste und die zweite Isolierschicht durch nur eine abgeschiedene Dielektrikum-Schicht (18) gebildet sind.

2. Vertikal-Transistor nach Anspruch 1,
**dadurch gekennzeichnet,**
**dass** die Dielektrikum-Schicht (18) aus Siliziumdioxid, Siliziumnitrid, Aluminiumoxid oder dergleichen besteht.

3. Vertikal-Transistor nach Anspruch 1 oder 2,
**dadurch gekennzeichnet,**
**dass** die Dielektrikum-Schicht (18) eine Schichtdicke von etwa 2 nm bis etwa 20 nm aufweist.

4. Verfahren zum Herstellen des Vertikal-Transistors nach einem der Ansprüche 1 bis 3,
**dadurch gekennzeichnet,**
**dass** die Dielektrikum-Schicht (18) durch ALD, CVD oder dergleichen hergestellt wird.
